# EUROPÄISCHE PATENTSCHRIFT

(11) **EP 2 695 503 B1**
(45) Veröffentlichungstag und Bekanntmachung des Hinweises auf die Patenterteilung: **18.10.2017**
(21) Anmeldenummer: 12709518.0
(22) Anmeldetag: 09.03.2012
(51) Int. Cl.: H05K 7/20

(54) **ANORDNUNG ZUM TEMPERIEREN EINES WÄRMEERZEUGENDEN BAUTEILS UND VERFAHREN ZUM HERSTELLEN EINER ANORDNUNG**
ASSEMBLY FOR THE TEMPERATURE CONTROL OF A HEAT-GENERATING COMPONENT AND METHOD FOR PRODUCING SUCH AN ASSEMBLY
SYSTÈME POUR RÉGULER LA TEMPÉRATURE D'UN COMPOSANT GÉNÉRATEUR DE CHALEUR ET PROCÉDÉ POUR FABRIQUER CE SYSTÈME

(30) Priorität: 01.04.2011 DE 102011015912
(43) Veröffentlichungstag der Anmeldung: 12.02.2014
(73) Patentinhaber: Sew-Eurodrive GmbH & Co. KG, 76646 Bruchsal (DE)
(72) Erfinder: NIKOLA, Joachim, 76703 Kraichtal (DE); SCHÖRNER, Martin, 76646 Bruchsal (DE)
(86) Internationale Anmeldenummer: PCT/EP2012/001055
(87) Internationale Veröffentlichungsnummer: WO 2012/130382

(56) Entgegenhaltungen:
- EP-A2- 2 040 526
- EP-A2- 2 273 859
- JP-A- 8 238 707
- US-A1- 2007 240 310

## Beschreibung

Die Erfindung betrifft eine Anordnung zum Temperieren eines wärmeerzeugenden Bauteils und ein Verfahren zum Herstellen einer Anordnung.

Es ist bekannt, ein wärmeerzeugendes Bauteil, wärmeleitend mit einem Kühlkörper zu verbinden.

**Aus der** US 2007/240310 A1 **ist ein Wärmemanagementsystem bekannt.**

**Aus der** EP 2 273 859 A2 **ist die Verwendung eines Steuermoduls für eine in einem Automatikgetriebe verbaute Getriebesteuerung bekannt.**

**Aus der** JP 8 238707 A **ist ein Wärmestrahlungsschild bekannt.**

**Aus der** EP 2 040 526 A2 **ist ein Steuergerät für ein Kraftfahrzeug bekannt.**

Der Erfindung liegt daher die Aufgabe zugrunde, eine Anordnung zum Temperieren eines wärmeerzeugenden Bauteils und ein Verfahren zum Herstellen einer solchen Anordnung weiterzubilden, wobei ein einfach herzustellendes und kostengünstiges Wärmetransportmittel geschaffen werden soll.

Erfindungsgemäß wird die Aufgabe bei der Anordnung zum Temperieren eines wärmeerzeugenden Bauteils nach den in Anspruch 1 und bei dem Verfahren zum Herstellen einer Anordnung nach den in Anspruch 12 angegebenen Merkmalen gelöst.

Wichtige Merkmale der Erfindung bei der Anordnung zum Temperieren eines wärmeerzeugenden Bauteils sind, dass die Anordnung zumindest einen Kunststoffabschnitt aufweist und ein Metallteil

wobei der Kunststoffabschnitt zwischen dem Bauteil und dem ersten Metallteil angeordnet ist,

wobei Kunststoffabschnitt eine oder mehrere Ausnehmungen aufweist, welche mit einem wärmeleitfähigen Beschichtungsmaterial beschichtet sind.

Von Vorteil ist dabei, dass die Wärme des Bauteils, insbesondere direkt oder über ein zweites Metallteil, an das Beschichtungsmaterial leitbar ist, welches die Wärme dann weiter leitet und über einen Kontaktbereich zwischen erstem Metallteil und Beschichtungsmaterial an das erste Metallteil leitet, welches die Wärme dann an die Umgebung abgibt.

Des Weiteren schützt der Kunststoff das Bauteil, da er dieses zumindest teilweise umgibt. Außerdem ist eine wärmetechnische Trennung des Bauteils von weiteren Bauteilen einfach ausgeführt. Somit sind Bauteile auf verschiedenem Temperaturniveau voneinander trennbar und über das Metallteil entwärmbar.

Bei einer vorteilhaften Ausgestaltung ist die spezifische Wärmeleitfähigkeit des Beschichtungsmaterial mindestens 100 mal, insbesondere 1000 mal, besser als die spezifische Wärmeleitfähigkeit des Kunststoffs. Von Vorteil ist dabei, dass eine effektive Entwärmung ermöglicht ist.

Bei einer vorteilhaften Ausgestaltung ist der Kunststoff ein Schaumstoff, insbesondere wobei der Kunststoff ein EPS oder ein EPP ist. Von Vorteil ist dabei, dass eine einfache kostengünstige Herstellung ermöglicht ist.

Bei einer vorteilhaften Ausgestaltung ist der Kunststoffabschnitt mehrteilig ausgeführt, wobei jeweils zwischen zwei Teilen eine jeweilige Schicht des Beschichtungsmaterials angeordnet ist. Von Vorteil ist dabei, dass ein schichtartiger Aufbau in einfacher Weise herstellbar ist, indem die Schichtteile separat lackiert werden und dann zusammengefügt werden.

Bei einer vorteilhaften Ausgestaltung sind die Ausnehmungen durchgehend, insbesondere von der dem Metallteil zugewandten Seite bis zu der dem Bauteil zugewandten Seite des Kunststoffabschnitts, ausgeführt und sind vollständig mit Beschichtungsmaterial ausgefüllt oder zumindest an der die Ausnehmung begrenzenden Wandung des Kunststoffabschnitts mit Beschichtungsmaterial beschichtet. Von Vorteil ist dabei, dass bei durchkontaktierten Ausnehmungen die Wärme auf dem kürzesten Weg transportierbar ist von dem wärmeerzeugenden Bauteil zu dem Kühlkörper. Außerdem ist Masse für den Wärmetransport einsparbar, indem nur die Wandung der Ausnehmungen mit Metall beschichtbar sind.

Bei einer vorteilhaften Ausgestaltung weist das Beschichtungsmaterial eine Lackschicht ist, also durch Auftragen von Lack hergestellt ist und/oder durch Eintauchen von Lack. Von Vorteil ist dabei, dass eine einfache Herstellung der Metallschicht durch Lackieren erreichbar ist. Denn hierzu ist nur ein Eintauchen in einen Lack notwendig.

Bei einer vorteilhaften Ausgestaltung sind die Ausnehmungen derart dünn, dass beim Herstellen Lack mittels Kapillarkraft die Ausnehmungen zumindest teilweise befüllt. Von Vorteil ist dabei, dass das Kunststoffteil nicht untergetaucht werden muss in den Lack sondern dass ein teilweises Eintauchen oder wenigstens Berühren des flüssigen Lacks bei der Herstellung ausreicht. Denn unter Kapillarkraftwirkung wird der flüssige Lack in die Ausnehmungen eingezogen. Bei geeigneter Materialwahl des Kunststoffs und des Lacks ist die relative Oberflächenspannung reduzierbar, so dass ein schnelles und selbsttätiges Einziehen des Lacks in die dünnen als Ausnehmungen fungierenden Spalte ermöglicht ist.

Bei einer vorteilhaften Ausgestaltung sind die Ausnehmungen zylindrisch oder quaderförmig ausgeführt. Von Vorteil ist dabei, dass eine einfache Herstellung ermöglicht ist.

Wichtige Merkmale bei dem Verfahren zum Herstellen einer Anordnung zum Temperieren eines wärmeerzeugenden Bauteils sind, dass
- ein Kunststoffabschnitt in ein Lackbad eingetaucht wird oder Lack auf den Kunststoffabschnitt aufgetragen und/oder aufgesprüht wird und/oder mittels Kapillarkräften Lack auf den Kunststoffabschnitt gezogen wird, so dass der Kunststoffabschnitt eine oder mehrere Ausnehmungen aufweist, welche mit einem wärmeleitfähigen Beschichtungsmaterial beschichtet sind,
- der Kunststoffabschnitt zwischen Bauteil und einem Metallteil, insbesondere Kühlkörper angeordnet wird.

Von Vorteil ist dabei, dass eine einfach herstellbare Entwärmung in einem Gerät herstellbar ist, wobei die wärmeerzeugenden Bauteile mit dem Kunststoffteil in Berührung bringbar sind, so dass sie nicht nur entwärmbar sondern auch mechanisch geschützt sind. Der Kunststoff übernimmt somit auch teilweise gehäusebildende Funktion, insbesondere beim Lagern einer Leiterplatte in einem Lager, wo der Kunststoff schon um die Leiterplatte mit den wärmeerzeugenden Bauteilen herum vorsehbar ist. Somit ist die im Lager gelagerte Leiterplatte geschützt. Das gesamte aus Leiterplatte und Kunststoff bestehende Modul wird als Einheit ausgeführt und bei der Herstellung des Elektrogeräts, insbesondere Umrichters, in ein Gehäuse eingeschoben und somit auch bei der Herstellung als die Leiterplatte schützendes Teil verwendet.

Bei einer vorteilhaften Ausgestaltung wird das Bauteil mit weiteren Bauteilen auf einer Leiterplatte bestückt angeordnet und in den Kunststoffabschnitt wird ein Abdruck der mit Bauteilen bestückten Leiterplatte einhüllenden Kontur eingedrückt. Von Vorteil ist dabei, dass das Kunststoffteil der Einhüllenden der Oberfläche der bestückten Leiterplatte folgend geformt ist. Dabei ist ein Hinterschnitt nicht ausfüllbar sondern nur die Einhüllende ausformbar, also derjenige Abdruck ausformbar, welcher zurückbleibt, wenn die bestückte Leiterplatte in den Kunststoffabschnitt eingerückt wird, also in linearer Richtung hineinbewegt und wieder zurückgezogen wird.

Bei einer vorteilhaften Ausgestaltung wird der Kunststoffabschnitt aus mehreren Teilen zusammengesetzt, die jeweils mit dem Beschichtungsmaterial beschichtet sind. Von Vorteil ist dabei, dass ein Schichtaufbau des Kunststoffabschnitts ausführbar ist, wobei jedes Einzelsegment beschichtet ausgeführt ist und somit nach Zusammensetzen ein Sandwichartiger Aufbau erreichbar ist und damit ein effektive Entwärmung der wärmeerzeugenden Teile, die auch breiter sein dürfen als die Wandstärke eines jeweiligen Einzelsegments.

Die Erfindung wird nun anhand von schematischen Abbildungen näher erläutert:

In der Figur 1 ist eine erfindungsgemäße Ausführungsform schematisch skizziert.

In der Figur 2 ist eine weitere erfindungsgemäße Ausführungsform skizziert, wobei zwei Varianten von durchgehenden Ausnehmungen (20, 21) gezeigt sind

In der Figur 3 ist eine weitere erfindungsgemäße Ausführungsform gezeigt, wobei mehrere verschieden große Wärmequellen adaptiert sind.

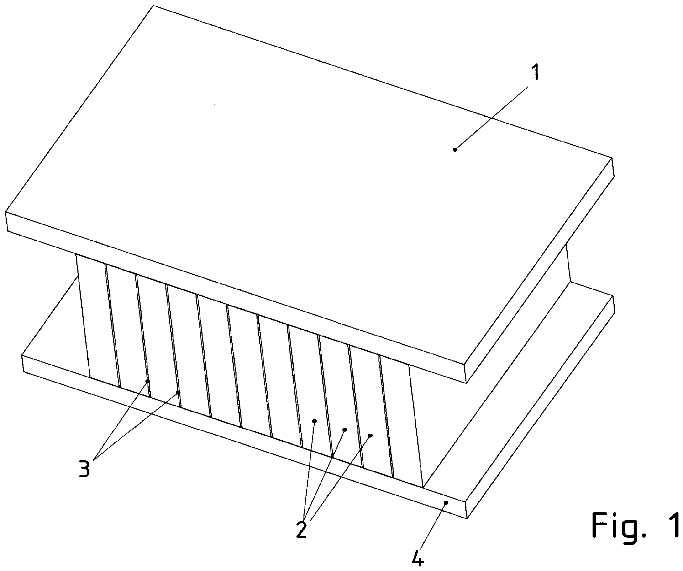

Wie in Figur 1 gezeigt, ist an einer Seite eines ersten Metallteils 1, insbesondere Aluminiumteil, ein Schaumstoff 2 oder Kunststoff verbunden, welcher Schichten von Metalllack 3 aufweist. An der vom ersten Metallteil 1 abgewandten Seite des Schaumstoffs 2 ist ein weiteres Metallteil 4 verbunden.

Zur Herstellung werden dabei Schaumstoffschichten, also plattenförmige Gebilde in den Metalllack, insbesondere also Kupfer-haltigen Lack, eingetaucht und danach zusammengefügt, so dass die in Figur 1 gezeigte Schichtstruktur entsteht.

Die Auftragung des wärmeleitenden Lacks, insbesondere Metalllacks 3, auf die plattenförmige Gebilde ist auch mehrschichtig ausführbar, also in mehreren Beschichtungsschritten, wobei zwischen jedem Beschichtungsschritt ein Trocknungspause ausgeführt wird. Zum Auftragen des Lacks ist auch ein Sprühen anstatt oder zusätzlich nachfolgend zum Eintauchen anwendbar.

Die jeweils beschichteten Gebilde werden dann zur Bildung des Schaumstoffabschnitts 2 verbunden oder lose aneinander gereiht. Beim Verbinden ist ein Verrasten, Verkleben, insbesondere unter Verwendung des Lacks, und/oder Verschrauben und/oder Verpressen vorteilhaft ausführbar.

Somit ist zwar der Schaumstoff 2 als schlechter Wärmeleiter zwischen den beiden Metallteilen (1, 4) angeordnet, aber der Metalllack 3 ist infolge des metallischen Anteils ein guter Wärmeleiter. Somit wird Wärme vom Metallteil 4 zum Metallteil 1 durchleitbar und es besteht also ein geringerer Wärmeübergangswiderstand zwischen Metallteil 4 und 1 als über den Schaumstoff 2 oder die Umgebung.

Auf diese Weise ist der Zwischenraum zwischen den Metallteilen 1 und 4 befüllt mit Schaumstoff 2, so dass Schwingungen abgedämpft werden und elektromagnetische Abstrahlungen in den Metalllackschichten 3 gedämpft werden beziehungsweise der strahlende Sender abgeschirmt wird.

Vorteiligerweise ist am Metallteil 4 eine Wärmequelle angeordnet, beispielsweise ein wärmeerzeugendes Bauteil. Das Metallteil 1 muss nicht als ebene Platte geformt sein, sondern ist auch als Kühlkörperteil ausführbar, beispielsweise mit an seiner Außenoberfläche angebrachten Kühlelementen, wie Kühlrippen, Kühlfingern oder anderen oberflächenvergrößernden Strukturen.

Als Wärmequelle ist beispielsweise ein Leistungsmodul verwendbar, welches mehrere elektronische Leistungshalbleiterschalter, IGBT oder MOSFET, aufweist. Das Metallteil 4 ist beispielsweise aus Aluminium oder Kupfer-haltigem Metall herstellbar.

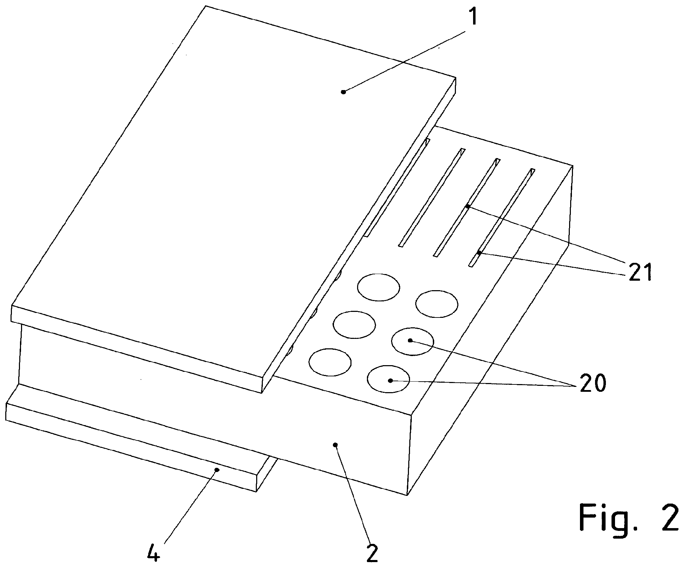

Wie in Figur 2 gezeigt, ist der Schaumstoff 2 mit durchgehenden runden Ausnehmungen 20 oder quaderförmigen durchgehenden Ausnehmungen 21 versehen.

Zur Herstellung werden in einen großen Schaumstoffabschnitt die Ausnehmungen eingebracht und danach der Schaumstoffabschnitt 2 eingetaucht in Metalllack, also Metall-, insbesondere Kupfer-, -haltigen Lack. Nach dem Herausziehen aus dem flüssigen Lack und nach dem nachfolgenden Abtrocknen wird der Kunststoffabschnitt 2 zwischen die Metallteil 1 und 4 angeordnet. Somit weist der Kunststoffabschnitt durchkontaktierte Ausnehmungen auf, wobei die Metalllackbeschichtung die Metallteil 1 und 4 berührt und Wärme transportiert.

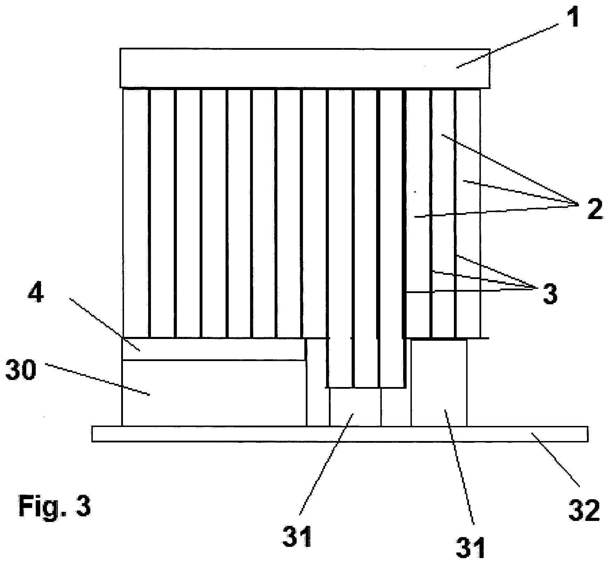

Wie in Figur 3 gezeigt ist der Schaumstoff zwischen dem als Kühlkörper oder dem als als Kühlkörper fungierenden Gehäuseteil vorgesehenen Metallteil 1 und einer mit Bauteilen (30, 31) bestückten Leiterplatte 32 vorgesehen, wobei er der Kontur einer bestückten Leiterplatte 32 folgend auf der vom Metallteil 1 abgewandten Seite geformt ist.

Dabei ist auf der Leiterplatte 32 nicht nur ein Leistungsbauteil 30 bestückt, welches eine große Wärmemenge erzeugt, sondern es sind auch kleinere und/oder andere Bauteile 31 bestückt, welche Wärme erzeugen.

Die Leiterplatte 32 ist eben ausgeführt. Da die auf derselben Seite bestückten Bauteile (30, 31) verschieden hoch sind, weist der Schaumstoff 2 dann entsprechend veränderliche Wandstärke auf.

Zur Aufspreizung der Temperatur und Vergleichmäßigung schwankender Wärmestromstärken, ist das Metallteil 4 auf dem Bauteil 30 angeordnet.

Statt Lack ist auch eine andere Flüssigkeit bei der Herstellung verwendbar, wenn ein Aushärten derart erreichbar ist, dass die beschriebene wärmeleitfähige Schicht hergestellt ist.

Bei weiteren erfindungsgemäßen Ausführungsbeispielen wird bei der Herstellung des Schaumstoffs 2 das Negativbild der bestückten Leiterplatte 32 in den Schaumstoff 2 als Abdruck eingeformt. Somit ist ein besonders einfaches und wenig aufwendiges Fügen des Schaumstoffabschnitts 2 beim Einbau in die erfindungsgemäße Anordnung ermöglicht.

Bei weiteren erfindungsgemäßen Ausführungsbeispielen wird als Schaumstoff oder Kunststoff 2 EPS oder EPP verwendet und/oder der Schaumstoff 2 weist unterschiedlich geformte Ausnehmungen (20, 21) auf. Statt der obengenannten Durchkontaktierung, wobei nur die Oberfläche der Ausnehmung beschichtet ist, ist auch ein volles Befüllen der Ausnehmungen (20, 21) ermöglicht. In Weiterbildung sind die Ausnehmungen auch derart dünn ausführbar, dass der Lack nicht durch Untertauchen in Lack sondern durch Einziehen in die Ausnehmungen mittels Kapillarwirkung in der Ausnehmung teilweise oder ganz verteilt wird.

Bei weiteren erfindungsgemäßen Ausführungsbeispielen wird ist als Schaumstoff oder mehrteiliger Kunststoff Styropor verwendet, wobei die Teile des mehrteiligen Kunststoffabschnitts dann im Wesentlichen kugelförmig oder zumindest rund sind, insbesondere wobei die Teile Styropor-Partikel sind, insbesondere Styroporkügelchen. Die Beschichtung umgibt dann die Partikel jeweils und bildet somit eine wärmeleitfähige Verbindung von der Wärmequelle zum Kühlkörper.

Bei weiteren erfindungsgemäßen Ausführungsbeispielen ist das Beschichtungsmaterial elektrisch leitfähig, so dass der Kühlkörper auf dem gleichen Potential wie die Wärmequelle anordenbar ist. Alternativ wird ein elektrisch isolierendes Beschichtungsmaterial verwendet, so dass nicht das gleiche Potential vorzusehen ist.

### Bezugszeichenliste

1 Metallteil, insbesondere Aluminiumteil
2 Schaumstoff oder Kunststoff
3 Metalllack
4 Metallteil
20 Ausnehmung, insbesondere durchgehend
21 Ausnehmung, insbesondere durchgehend
30 Leistungsbauteil
31 Bauteil, insbesondere wärmeerzeugendes
32 Leiterplatte

## Patentansprüche

1. Anordnung zum Temperieren eines wärmeerzeugenden Bauteils,
wobei die Anordnung zumindest einen Kunststoffabschnitt aufweist und ein Metallteil (1, 4)
wobei der Kunststoffabschnitt zwischen dem Bauteil und dem Metallteil (1, 4) angeordnet ist,
**wobei**
- Kunststoffabschnitt eine oder mehrere Ausnehmungen (20, 21) aufweist, welche mit einem Beschichtungsmaterial, insbesondere mit einem wärmeleitfähigen Beschichtungsmaterial, beschichtet sind, wobei das Beschichtungsmaterial wärmeleitfähiger als der Kunststoff ist,
- und/oder dass der Kunststoffabschnitt mehrteilig ausgeführt ist, wobei jeweils zwischen zwei Teilen eine jeweilige Schicht eines Beschichtungsmaterials, insbesondere eines wärmeleitfähigen Beschichtungsmaterials, angeordnet ist, wobei das Beschichtungsmaterial wärmeleitfähiger als der Kunststoff ist,
insbesondere wobei das Beschichtungsmaterial elektrisch leitfähig oder isolierend ist,
**dadurch gekennzeichnet, dass**
**der Kunststoff ein Schaumstoff (2) ist, insbesondere wobei der Kunststoff ein EPS oder ein EPP ist**
**wobei der Kunststoffabschnitt mehrteilig ausgeführt ist, wobei jeweils zwischen zwei Teilen eine jeweilige Schicht eines wärmeleitfähigen Beschichtungsmaterials angeordnet ist**
**wobei die Ausnehmungen (20, 21) durchgehend, von der dem Metallteil (1, 4) zugewandten Seite bis zu der dem Bauteil zugewandten Seite des Kunststoffabschnitts ausgeführt sind und vollständig mit Beschichtungsmaterial ausgefüllt sind oder zumindest an der die Ausnehmung (20, 21) begrenzenden Wandung des Kunststoffabschnitts mit Beschichtungsmaterial beschichtet sind.**

2. Anordnung nach Anspruch 1,
**dadurch gekennzeichnet, dass**
die spezifische Wärmeleitfähigkeit des Beschichtungsmaterial mindestens 100 mal, insbesondere mindestens 1000 mal, höher ist als die spezifische Wärmeleitfähigkeit des Kunststoffs.

3. Anordnung nach mindestens einem der vorangegangenen Ansprüche,
**dadurch gekennzeichnet, dass**
die Teile des mehrteiligen Kunststoffabschnitts kugelförmig oder zumindest rund sind, insbesondere wobei die Teile Styropor-Partikel sind, insbesondere Styroporkügelchen.

4. Anordnung nach mindestens einem der vorangegangenen Ansprüche,
**dadurch gekennzeichnet, dass**
das Beschichtungsmaterial eine Lackschicht ist, also durch Auftragen von Lack (3) hergestellt ist und/oder durch Eintauchen von Lack (3).

5. Anordnung nach mindestens einem der vorangegangenen Ansprüche,
**dadurch gekennzeichnet, dass**
die Ausnehmungen (20, 21) derart dünn sind, dass beim Herstellen Lack (3) mittels Kapillarkraft die Ausnehmungen (20, 21) zumindest teilweise befüllt.

6. Anordnung nach mindestens einem der vorangegangenen Ansprüche,
**dadurch gekennzeichnet, dass**
die Ausnehmungen (20, 21) zylindrisch oder quaderförmig ausgeführt sind.

7. Anordnung nach mindestens einem der vorangegangenen Ansprüche,
**dadurch gekennzeichnet, dass**
als Beschichtungsmaterial einen wärmeleitfähigen Stoff, wie Metall oder Keramik, enthaltender Lack (3), insbesondere ein Kupfer oder Keramik, enthaltender Lack (3), verwendet ist,
insbesondere wobei der Stoff als Pulver dem Lack (3) beigemischt ist.

8. Anordnung nach mindestens einem der vorangegangenen Ansprüche,
**dadurch gekennzeichnet, dass**
statt Lack (3) eine andere aushärtende Flüssigkeit bei der Herstellung verwendet ist.

9. Verfahren zum Herstellen einer Anordnung, insbesondere nach mindestens einem der vorangegangenen Ansprüche, zum Temperieren eines wärmeerzeugenden Bauteils,
**dadurch gekennzeichnet, dass**
- ein Kunststoffabschnitt in ein Lackbad eingetaucht wird oder Lack (3) auf den Kunststoffabschnitt aufgetragen und/oder aufgesprüht wird und/oder mittels Kapillarkräften Lack (3) auf den Kunststoffabschnitt gezogen wird, so dass der Kunststoffabschnitt eine oder mehrere Ausnehmungen (20, 21) aufweist, welche mit einem wärmeleitfähigen Beschichtungsmaterial beschichtet sind,
- der Kunststoffabschnitt zwischen Bauteil und einem Metallteil (1, 4), insbesondere Kühlkörper angeordnet wird,
**wobei das Bauteil mit weiteren Bauteilen auf einer Leiterplatte (32) bestückt angeordnet wird und in den Kunststoffabschnitt ein Abdruck der mit Bauteilen bestückten Leiterplatte (32) einhüllenden Kontur eingedrückt wird.**

10. Verfahren nach Anspruch 9,
**dadurch gekennzeichnet, dass**
der Kunststoffabschnitt aus mehreren Teilen zusammengesetzt wird, die jeweils mit dem Beschichtungsmaterial beschichtet sind.

11. Verfahren nach Anspruch 9 oder 10,
**dadurch gekennzeichnet, dass**
die Teile des mehrteiligen Kunststoffabschnitts kugelförmig oder zumindest rund sind.

12. Verfahren nach Anspruch 9, 10 oder 11,
**dadurch gekennzeichnet, dass**
**durch das Auftragen von Lack (3) und/oder das Eintauchen von Lack (3) eine Lackschicht als Beschichtungsmaterial erzeugt wird.**

13. Verfahren nach Anspruch 9, 10, 11 oder 12,
**dadurch gekennzeichnet, dass**
**die Ausnehmungen (20, 21) derart dünn und der Lack (3) derart ausgewählt** sind, dass beim Herstellen Lack (3) mittels Kapillarkraft die Ausnehmungen (20, 21) zumindest teilweise befüllt.

## Claims

1. Arrangement for the temperature control of a heat-generating component,
wherein the arrangement has at least one plastic section and a metal part (1, 4),
wherein the plastic section is arranged between the component and the metal part (1, 4),
wherein
- the plastic section has one or a plurality of openings (20, 21) which are coated with a coating material, in particular with a thermally conductive coating material, wherein the coating material is more thermally conductive than the plastic,
- and/or that the plastic section is formed of a plurality of parts, wherein between each two parts a respective layer of a coating material, in particular of a thermally conductive coating material, is arranged, wherein the coating material is more thermally conductive than the plastic,
in particular wherein the coating material is electrically conductive or insulating,
**characterised in that**
the plastic is a foam plastic (2), in particular wherein the plastic is an EPS or an EPP,
wherein the plastic section is formed of a plurality of parts,
wherein between each two parts a respective layer of a thermally conductive coating material is arranged,
wherein the openings (20, 21) are formed to pass right through, from the side facing the metal part (1, 4) to the side of the plastic section facing the component, and are completely filled with coating material or at least at the wall of the plastic section bounding the opening (20, 21) are coated with coating material.

2. Arrangement according to Claim 1,
**characterised in that**
the specific thermal conductivity of the coating material is at least 100 times, in particular at least 1000 times, higher than the specific thermal conductivity of the plastic.

3. Arrangement according to at least one of the preceding claims,
**characterised in that**
the parts of the plastic section formed of a plurality of parts are spherical or at least round, in particular wherein the parts are expanded polystyrene particles, in particular expanded polystyrene beads.

4. Arrangement according to at least one of the preceding claims,
**characterised in that**
the coating material is a coat of lacquer, i.e. is produced by applying lacquer (3) and/or by immersing in lacquer (3).

5. Arrangement according to at least one of the preceding claims,
**characterised in that**
the openings (20, 21) are so thin that, during production, lacquer (3) at least partly fills the openings (20, 21) by means of capillary action.

6. Arrangement according to at least one of the preceding claims,
**characterised in that**
the openings (20, 21) are of cylindrical or cuboid form.

7. Arrangement according to at least one of the preceding claims,
**characterised in that**
as coating material a lacquer containing a thermally conductive substance, such as metal or ceramic, in particular lacquer (3) containing a copper or ceramic, is used,
in particular wherein the substance is admixed to the lacquer (3) as powder.

8. Arrangement according to at least one of the preceding claims,
**characterised in that**
instead of lacquer (3) another curing liquid is used during the production.

9. Method for producing an arrangement, in particular according to at least one of the preceding claims, for the temperature control of a heat-generating component,
**characterised in that**
- a plastic section is immersed in a lacquer bath or lacquer (3) is applied to and/or sprayed onto the plastic section and/or lacquer (3) is drawn onto the plastic section by means of capillary action, so that the plastic section has one or a plurality of openings (20, 21) which are coated with a thermally conductive coating material,
- the plastic section is arranged between the component and a metal part (1, 4), in particular cooling body,
wherein the component is fitted with further components on a printed circuit board (32) and an impression of the contour enveloping the printed circuit board (32) fitted with components is impressed in the plastic section.

10. Method according to Claim 9,
**characterised in that**
the plastic section is composed of a plurality of parts which are each coated with the coating material.

11. Method according to Claim 9 or 10,
**characterised in that**
the parts of the plastic section composed of a plurality of parts are spherical or at least round.

12. Method according to Claim 9, 10 or 11,
**characterised in that**
a coat of lacquer is produced as coating material by the applying of lacquer (3) and/or the immersing in lacquer (3).

13. Method according to Claim 9, 10, 11 or 12,
**characterised in that**
the openings (20, 21) are chosen to be so thin and the lacquer (3) to be of such a kind that, during production, lacquer (3) at least partly fills the openings (20, 21) by means of capillary action.

## Revendications

1. Système pour réguler la température d'un composant générateur de chaleur,
lequel système présente au moins une section en matière plastique et un élément métallique (1, 4),
la section en matière plastique étant disposée entre le composant et l'élément métallique (1, 4),
dans lequel
- la section en matière plastique présente un ou plusieurs évidements (20, 21) qui sont revêtus d'un matériau de revêtement, en particulier d'un matériau de revêtement thermoconducteur, le matériau de revêtement étant plus thermoconducteur que la matière plastique,
- et/ou la section en matière plastique est réalisée en plusieurs parties, une couche respective d'un matériau de revêtement, en particulier d'un matériau de revêtement thermoconducteur, étant chaque fois disposée entre deux parties, le matériau de revêtement étant plus thermoconducteur que la matière plastique,
le matériau de revêtement étant en particulier électriquement conducteur ou isolant, c
**aractérisé en ce que**
la matière plastique est une mousse (2), la matière plastique étant en particulier un EPS ou un EPP,
la section en matière plastique étant réalisée en plusieurs parties, une couche respective d'un matériau de revêtement thermoconducteur étant chaque fois disposée entre deux parties,
les évidements (20, 21) étant réalisés traversants, du côté tourné vers l'élément métallique (1, 4) au côté tourné vers le composant de la section en matière plastique, et étant entièrement remplis de matériau de revêtement ou au moins revêtus de matériau de revêtement sur la paroi de la section en matière plastique délimitant l'évidement (20, 21).

2. Système selon la revendication 1,
**caractérisé en ce que**
la conductivité thermique spécifique du matériau de revêtement est au moins 100 fois, en particulier au moins 1000 fois plus élevée que la conductivité thermique spécifique de la matière plastique.

3. Système selon au moins l'une des revendications précédentes,
**caractérisé en ce que**
les parties de la section en matière plastique en plusieurs parties sont sphériques ou au moins rondes, les parties étant en particulier des particules de polystyrène, en particulier des billes de polystyrène.

4. Système selon au moins l'une des revendications précédentes,
**caractérisé en ce que**
le matériau de revêtement est une couche de peinture, donc réalisée par application d'une peinture (3) et/ou par immersion dans une peinture (3).

5. Système selon au moins l'une des revendications précédentes,
**caractérisé en ce que**
les évidements (20, 21) sont assez minces pour que la peinture (3) remplisse au moins partiellement les évidements (20, 21) par capillarité lors de la fabrication.

6. Système selon au moins l'une des revendications précédentes,
**caractérisé en ce que**
les évidements (20, 21) sont réalisés avec une forme cylindrique ou parallélépipédique.

7. Système selon au moins l'une des revendications précédentes,
**caractérisé en ce que**
l'on utilise comme matériau de revêtement une peinture (3) contenant une substance thermoconductrice, telle qu'un métal ou une céramique, en particulier une peinture (3) contenant du cuivre ou une céramique,
la substance étant en particulier mélangée à la peinture (3) sous forme de poudre.

8. Système selon au moins l'une des revendications précédentes,
**caractérisé en ce que**
l'on utilise un autre liquide durcissant à la place d'une peinture (3) lors de la fabrication.

9. Procédé de fabrication d'un système, en particulier selon au moins l'une des revendications précédentes, pour réguler la température d'un composant générateur de chaleur,
**caractérisé en ce**
- **qu'**une section en matière plastique est immergée dans un bain de peinture ou une peinture (3) est appliquée et/ou pulvérisée sur la section en matière plastique et/ou une peinture (3) est étendue sur la section en matière plastique au moyen de forces capillaires, de sorte que la section en matière plastique présente un ou plusieurs évidements (20, 21) qui sont revêtus d'un matériau de revêtement thermoconducteur,
- la section en matière plastique est disposée entre le composant et un élément métallique (1, 4), en particulier un dissipateur de chaleur,
le composant étant disposé avec d'autres composants sur une carte de circuit imprimé (32) de manière à équiper celle-ci et une empreinte du contour d'enveloppe de la carte de circuit imprimé (32) équipée des composants étant réalisée dans la section en matière plastique.

10. Procédé selon la revendication 9,
**caractérisé en ce que**
la section en matière plastique est composée de plusieurs parties qui sont chacune revêtues du matériau de revêtement.

11. Procédé selon la revendication 9 ou 10,
**caractérisé en ce que**
les parties de la section en matière plastique en plusieurs parties sont sphériques ou au moins rondes.

12. Procédé selon la revendication 9, 10 ou 11,
**caractérisé en ce**
**qu'**une couche de peinture est produite en tant que matériau de revêtement par application d'une peinture (3) et/ou par immersion dans une peinture (3).

13. Procédé selon la revendication 9, 10, 11 ou 12,
**caractérisé en ce que**
les évidements (20, 21) sont assez minces et la peinture (3) choisie de telle sorte que la peinture (3) remplisse au moins partiellement les évidements (20, 21) par capillarité lors de la fabrication.
